# EUROPÄISCHE PATENTSCHRIFT

(11) **EP 1 442 309 B1**
(45) Veröffentlichungstag und Bekanntmachung des Hinweises auf die Patenterteilung: **06.04.2011**
(21) Anmeldenummer: 02781283.3
(22) Anmeldetag: 24.10.2002
(51) Int. Cl.: G01R 31/00

(54) **VERFAHREN UND SCHALTUNGSANORDNUNG ZUR ERKENNUNG EINES DEFEKTS VON HALBLEITERSCHALTELEMENTEN UND DEREN VERWENDUNG IN ELEKTRONISCHEN BREMSKRAFT- UND FAHRDYNAMIKREGLERN**
METHOD AND CIRCUIT FOR DETECTING A FAULT OF SEMICONDUCTOR CIRCUIT ELEMENTS AND USE THEREOF IN ELECTRONIC REGULATORS OF BRAKING FORCE AND OF DYNAMICS MOVEMENT OF VEHICLES
PROCEDE ET CIRCUIT DE DETECTION D'UN DEFAUT D'ELEMENTS DE CIRCUIT SEMI-CONDUCTEUR ET SON UTILISATION DANS DES REGULATEURS ELECTRONIQUES DE FORCE DE FREINAGE ET DE DYNAMIQUE DU MOUVEMENT DES VEHICULES

(30) Priorität: 09.11.2001 DE 10154763
(43) Veröffentlichungstag der Anmeldung: 04.08.2004
(73) Patentinhaber: Continental Teves AG & Co. oHG, 60488 Frankfurt (DE)
(72) Erfinder: ENGELMANN, Mario, 61449 Steinbach/Ts. (DE); FEY, Wolfgang, 65527 Niedernhausen (DE); OEHLER, Peter, 65929 Frankfurt-Höchst (DE)
(86) Internationale Anmeldenummer: PCT/EP2002/011886
(87) Internationale Veröffentlichungsnummer: WO 2003/039904

(56) Entgegenhaltungen:
- EP-A- 1 103 817
- DE-A- 10 057 486
- US-A- 5 079 456
- US-B1- 6 226 602

## Beschreibung

Die Erfindung betrifft ein Verfahren zur Erkennung eines Defekts von Halbleiterschaltelementen, insbesondere von Halbleiterschaltelementen nach dem Feldeffekt, sowie eine Schaltungsanordnung gemäß Oberbegriff von Anspruch 9 und deren Verwendung gemäß Anspruch 15.

Elektronische Steuergeräte für Kraftfahrzeugbremsanlagen führen in zunehmendem Maße Funktionen aus, die entweder zur Fahrsicherheit beitragen oder neuerdings sogar grundlegende Fahrzeugfunktionen, wie die Bremsfunktion als solches, umfassen. Beispiele für Funktionen zur Verbesserung der Fahrsicherheit sind die Blockierschutzregelung (ABS) oder die Fahrdynamikregelung (ESP: Elektronisches Stabilitäts Programm). Die Bremsfunktion als solches wird in neueren elektronischen Bremssystemen, wie der Elektrohydraulischen Bremse (EHB) oder der Elektromechanischen Bremse (EMB), durch das elektronische Steuergerät der Bremse übernommen.

Es werden daher immer größere Anforderungen an die Zuverlässigkeit, Fehlertoleranz und die Fehlerbehandlung der elektronischen Steuergeräte gestellt.

Es ist z.B aus der DE 10097486 bekannt, in elektronischen Steuergeräten für Kraftfahrzeugbremssysteme Sicherheitseinrichtungen vorzusehen, mit denen auftretende Defekte der darin enthaltenen elektronischen Bauelemente erkannt werden können. Bei Erkennung eines solchen Defekts können geeignete Gegenmaßnahmen, wie beispielsweise die Abschaltung des Steuergeräts oder die Umschaltung des Steuergeräts in einen Notfallmodus, vorgenommen werden. Zur Erkennung von Defekten können sicherheitsrelevante Schaltungsteile doppelt oder mehrfach (redundant) ausgeführt sein. Durch Vergleich der Funktion der mehrfach vorhandenen Schaltungsteile können auftretende Fehler in vielen Fällen erkannt werden.

Die Erfindung schlägt ein Verfahren zur Erkennung eines Defekts von elektronischen Bauelementen gemäß Anspruch 1 und eine Schaltungsanordnung gemäß Anspruch 12 vor.

In elektronischen Reglern werden Halbleiterbauelemente, wie Leistungsfeldeffekttransistoren (Power-MOSFETs, FETs), unter anderem zur Ansteuerung der elektromechanischen Hydraulikventile, die zur Regelung des Bremsdrucks vorgesehen sind, eingesetzt.

Mit dem Verfahren nach der Erfindung, welches in einem elektronischen Steuergerät, insbesondere für Bremsen- oder Fahrdynamikregler, durchgeführt wird, kann ein Defekt von elektronischen Bauelementen, wie z.B. FETs, welche vorzugsweise mindestens einer Leistungstreiberstufe und/oder mindestens einer Rezirkulationstreiberstufe zugeordnet sind, erkannt werden.

Die Leistungstreiberstufe und/oder die Rezirkulationstreiberstufe umfaßt bevorzugt elektronische Bauelemente, wie insbesondere ein oder mehrere Halbleiterschaltelement/-e und/oder eine oder mehrere Strommeßeinrichtung/-en.

Vorzugsweise ist jeweils eine Leistungstreiberstufe an eine Last angeschlossen, wobei die Last insbesondere eine induktive Last, z.B. eine Ventilspule, ist.

Zur Messung des Stroms werden als Halbleiterschaltelemente bevorzugt Sense-Halbleiter-Schaltelemente eingesetzt. Bei den Sense-Halbleiter-Schaltelementen handelt es sich vorzugsweise um Sense-FETs.

Unter einer redundanten Strommessung wird die Überprüfung des Stromes in einem redundanten Schaltungsaufbau mit mindestens zwei Strommeßeinrichtungen verstanden, wobei die Strommesseinrichtungen parallel oder in Reihe zueinander angeordnet sein können.

Neben einer Messung des Stroms am Ausgang eines Halbleiterschaltelements, zum Beispiel bei einem FET der Messung des Drain-Source-Stroms, kann es zur Überwachung der ordnungsgemäßen Funktion dieses Halbleiters auch zweckmäßig sein den Strom zwischen der Steuerleitung des Halbleiterschalters und einem der Ausgänge, z.B. den Gate-Source-Strom zu bestimmen.

Neben der mehrfachen Ausführung einzelner Bauelemente zum Zwecke der redundanten Strommessung kann es zusätzlich zweckmäßig sein, zur Erhöhung der Betriebssicherheit mindestens zwei Halbleiterschaltelemente einzusetzen, die den gleichen Ausgang schalten. Dabei kann insbesondere an jedem dieser Bauelemente eine eigene Strommessung durchgeführt werden. Bei diesen einen gleichen Ausgang schaltenden Halbleiterschaltern ist bevorzugt die Steuerleitung der Halbleiterschalter gemeinsam durch einen Signaleingang angesteuert. Unter einer Ansteuerung eines Ausgangs mit mehreren Halbleiterschaltelementen wird auch verstanden, wenn durch einen oder mehrere dieser Halbleiterschalter Induktionsströme von am Ausgang angeschlossenen induktiven Lasten geschaltet werden.

Wird ein Defekt eines Bauelements gemäß dem Verfahren nach der Erfindung erkannt, wird bevorzugt eine oder mehrere der Maßnahmen aus der Gruppe - Aktivieren eines Ersatzbauelementes für das ausgefallene Halbleiterbauelement, - Abschalten des Bremsenregelungssystems, - Aktivierung eins Teilbetriebs oder - Anzeige eines Fehlersignals auf dem Armaturenbrett durchgeführt.

Die Erfindung betrifft auch eine Schaltungsanordnung umfassend ein oder mehrere Halbleiterschaltelemente mit jeweils Steuerkontakten zum Anschluß einer Steuerleitung, mit Stromkontakten zum anschließen von vorzugsweise induktiven Lasten (z.B. Ventilspulen) und einer Strommeßeinrichtung zur Bestimmung des durch das Halbleiterschaltelement geführten Stroms (I_{LS} bzw. I_{LS}), insbesondere zur Durchführung des oben beschriebenen erfindungsgemäßen Verfahrens, bei der mindestens zwei getrennte Strommeßeinrichtungen, ggf. mit zum Teil einem oder mehreren gemeinsamen Bauelementen (Rₛ*), insbesondere Widerstandsbauelementen, für eine redundante Strommessung vorgesehen sind.

Bevorzugt wird die Strommessung durch Messung des Spannungsabfalls an Widerstandselementen bestimmt. Widerstandselemente können bei Integration auf einem Substrat on-chip Widerstände oder bevorzugt diskrete Widerstandselemente sein, wobei sich die letzgenannten gegenüber on-chip Widerständen mit geringeren Toleranzen fertigen lassen.

Die Erfindung betrifft auch die Verwendung der zuvor beschriebenen Schaltungsanordnung in elektronischen Bremskraft- oder Fahrdynamikreglern für Kraftfahrzeuge.

Bevorzugte Ausführungsformen der Erfindung ergeben sich aus den Unteransprüchen und der nachfolgenden Figurenbeschreibung, die einige Ausführungsbeispiele gemäß der Erfindung enthält.

Es zeigen
- Fig. 1: eine Schaltungsanordnung mit einem Sense-FET zum Schalten einer Last mit einer Strommeßeinrichtung,
- Fig. 2: eine Schaltungsanordnung zum Schalten einer Last mit redundanter Strommeßeinrichtung,
- Fig. 3: eine Schaltungsanordnung mit parallel geschalteten Sense-FETs mit jeweils einer Strommeßeinrichtung,
- Fig. 4: eine Schaltungsanordnung zum Schalten mehrerer Lasten mit Strommeßeinrichtungen und einem externen Referen- zwiderstand,
- Fig. 5: eine Schaltungsanordnung mit Rezirkulationstreiber und
- Fig. 6: ein Diagramm mit Strom- und Signal-Verläufen der Schaltungsanordnung zur Erläuterung der Schaltung ge- mäß Fig. 5.

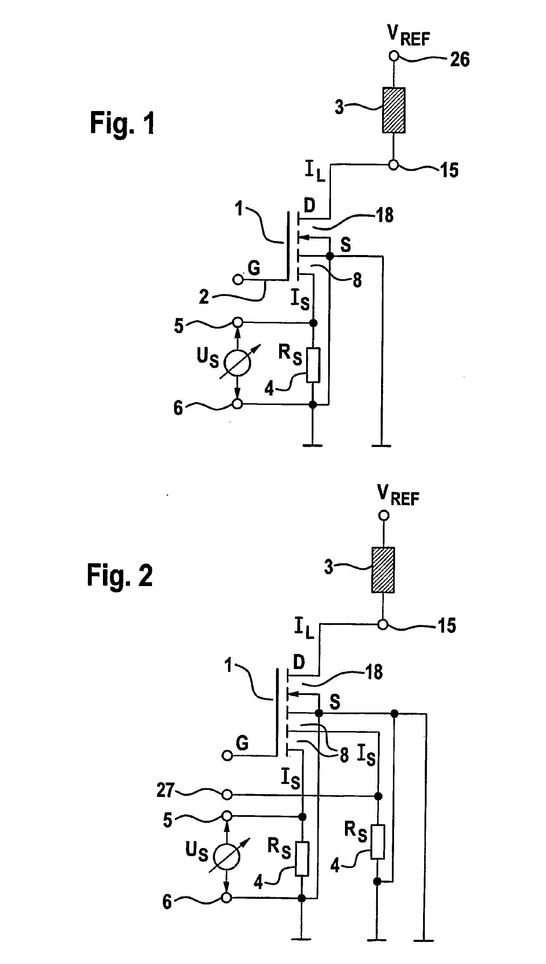

In der Schaltungsanordnung nach Fig. 1 ist ein Sense-FET 1 mit Klemme 15, welche zu einer Last 3 (z.B. Ventilspule) führt, verbunden. Nach Maßgabe der Gatespannung an Gate G fließt durch Last 3 ein Strom I_{L}. Der zweite Anschluß der Last (Klemme 26) ist mit dem positiven Potential V_{REF} mit einer Spannung zum Bezugspotential V_{REF} verbunden. Zur Messung des Laststroms kann der zusätzliche Sense-Ausgang eines Sense-FETs 1 genutzt werden, in dem der wesentlich kleinere Sense-Strom Iₛ fließt. Zur Umwandlung des Stroms in ein Spannungssignal Uₛ ist der Sense-Ausgang über Widerstand Rₛ zum Bezugspotential geführt.

Die Funktionsweise eines Sense-FET geht beispielsweise aus dem Patent US 5,079,456 oder der Patentanmeldung DE 195 20 735 A1 hervor. Demnach kann der Laststrom eines Leistungs-FETs 18 dadurch erfaßt werden, daß dem Leistungs-FET 18 auf dem Halbleitermaterial in unmittelbarer Nähe ein ähnlicher, von der Fläche her kleinerer FET 8, parallel geschaltet wird. Der durch den kleineren FET fließende Strom Iₛ ist zum Laststrom des Leistungs-FET weitestgehend proportional, jedoch ist der Strom Iₛ um ein strukturell festgelegtes Zahlenverhältnis kleiner als der Laststrom, welches dem Verhältnis an verbrauchter Chipfläche zwischen Leistungs-FET und Sense-FET im wesentlichen entspricht.

In Fig. 2 ist ein Sense-FET dargestellt, welcher im Gegensatz zum Sense-FET in Fig. 1 zwei redundanten Sense-FET Bereiche 8 umfaßt. Beide Sense-FET Bereiche sind jeweils über einen eigenen Meßwiderstand 4 (Rₛ) zum Bezugspotential geführt, so daß eine redundante Strommessung durchgeführt werden kann. Die Spannung Uₛ, die zum Laststrom proportional ist, kann zwischen Klemmen 5 und 6 und zwischen Klemmen 27 und 6 abgegriffen werden.

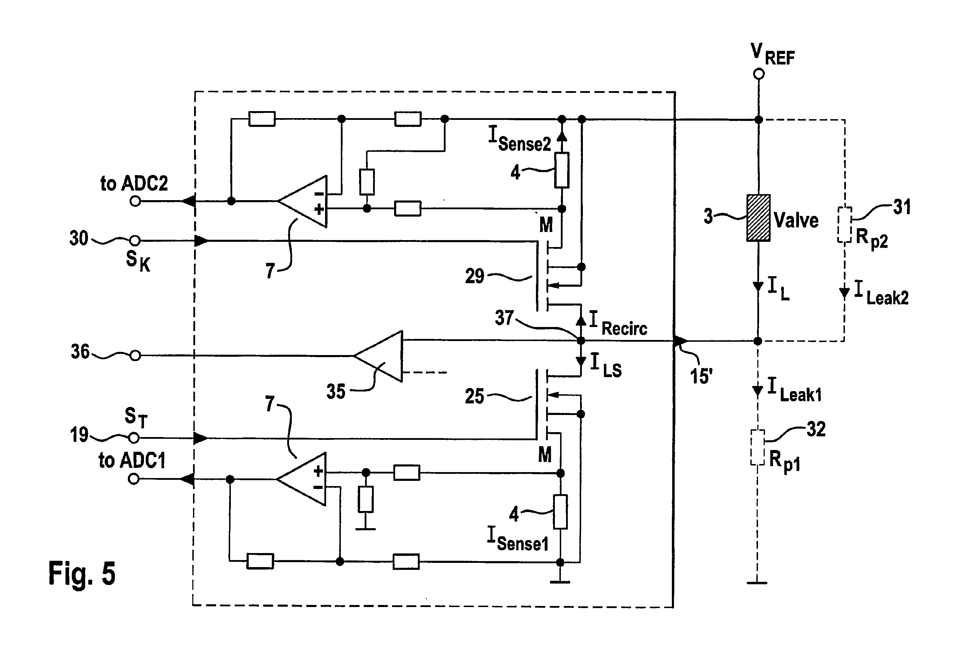

Die hier dargestellte Schaltungsanordnung ist im Gegensatz zur Schaltungsanordung gemäß Fig. 5 jedoch auf die Erkennung von Fehlern des Meßwiderstands 4 oder Fehler des Sense-FETs, die sich auch auf das Sense-FET Gebiet des Halbleiters ausdehnen, z.B. bei vollständigem Durchbrennen des Bauelements, beschränkt.

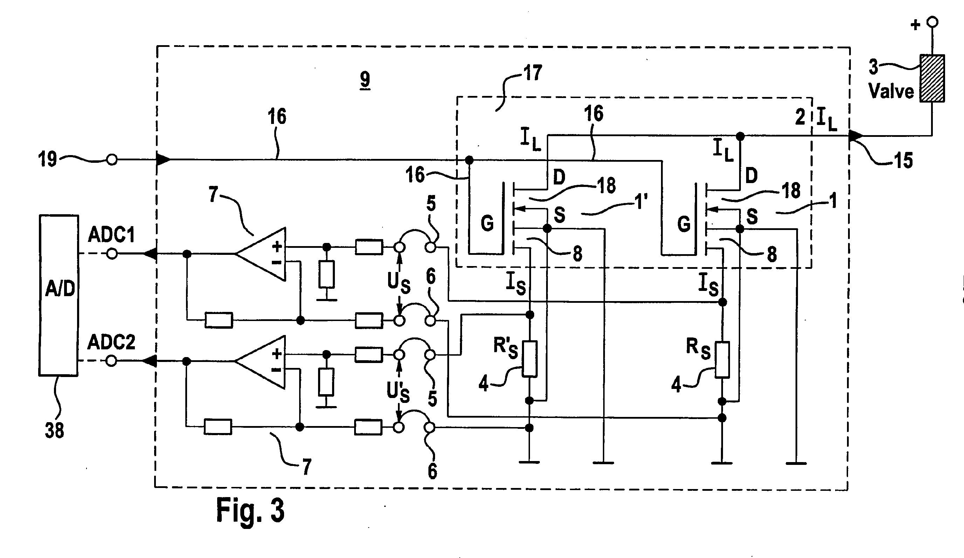

Die Schaltungsanordnung in Fig. 3, bei der alle wesentlichen Bauelemente auf einem Halbleitersubstrat 9 zusammengefaßt sind, umfaßt zwei parallel geschaltete Sense-FETs 1 und 1' zur Ansteuerung einer Last 3. Durch den gestrichelten Rahmen 17 wird hervorgehoben, daß Sense FETs 1 und 1' als eine gemeinsame Treiberstufe aufgefaßt werden können.

Neben Schaltelementen 1 und 1' umfaßt Substrat 9 zwei Strommeßeinrichtungen aus Referenzwiderständen 4 und Signalverstärkern 7 mit denen die an Widerständen 4 abfallenden jeweiligen Spannungen gemessen werden können. Die gemessenen Spannungen können dann über Ausgänge ADC1 und ADC2 einem oder mehreren A/D-Wandlern 38 zugeführt werden. Klemme 15 der Schaltungsanordnung ist als Low-Side-Schalter mit Last 3 verbunden. Klemme 15 führt auf dem Substrat zu den Drain-Zonen D der Sense-FETs 1 und 1'. Die Gates G der Sense FETs sind gemeinsam über Steuerleitungen 16 zur Klemme 19 geführt, über die von einer nichtgezeichneten Logik ein Steuersignal zugeführt werden kann. Mit den Sense-FET Bereichen der Schaltelemente 1 und 1' sind jeweils diskrete Widerstandsbauelemente Rₛ, Rₛ zur Bildung einer stromproportionalen Spannung verbunden. Die an Widerständen Rₛ abfallende Spannung kann schließlich mittels Verstärkerstufen 7 abgegriffen werden.

Sense-FETs 1 und 1' in Fig. 3 sind auf dem Halbleitersubstrat bevorzugt nicht unmittelbar nebeneinander angeordnet, so daß ein Defekt eines Halbleiterelements und die aufgrund des Defekts auftretende lokale Wärme, keinen Defekt des weiteren Halbleiterelements verursacht.

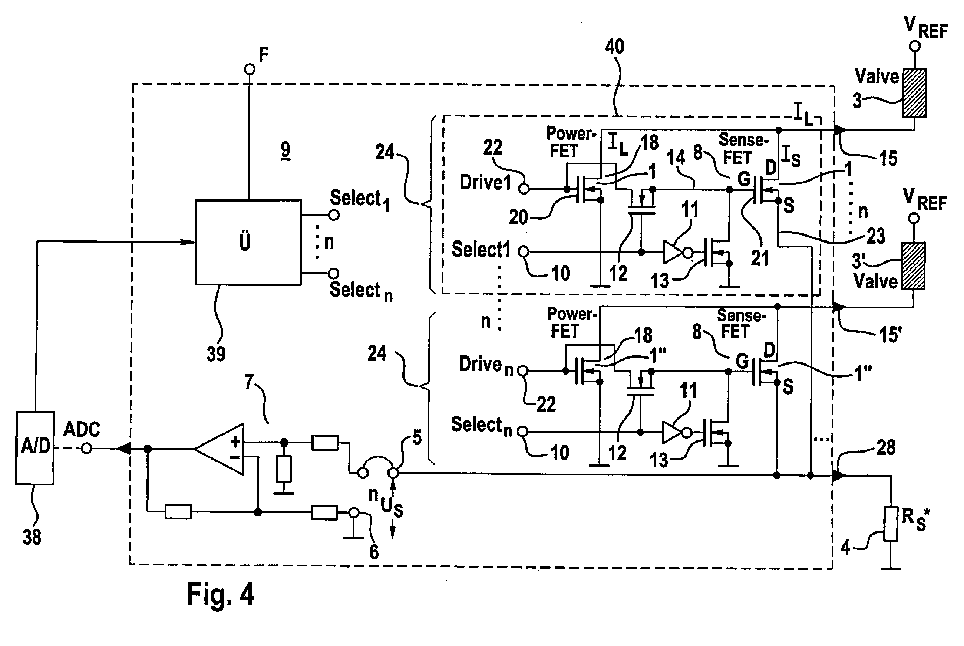

Die Schaltungsanordnung in Fig. 4 zeigt eine Ausführungsform mit mehreren Treibern 24 zum Schalten jeweils einer dem Treiber zugeordneten Lasten 3,3'. Auch hier werden wie in Fig. 3 die Lasten mittels Sense-FETs angesteuert, jedoch wird hier, wie weiter unten erläutert wird, aus Darstellungsgründen eine von Fig. 3 abweichende aufgeschlüsselte Darstellungsweise der Sense-FETs 1 und 1" benutzt. In Fig. 4 ist Sense-Stromteil 8 des Sense FETs 1 als eigenständiges FET-Symbol dargestellt. Der Laststrom-Teil 18 des Power-FETs 1 ist ebenfalls als getrenntes FET-Symbol gekennzeichnet.

Im Gegensatz zu Fig. 3 wird die Strommessung unter Verwendung eines externen diskreten Meßwiderstands 4 durchgeführt, mit dem die Sense-Teile 8 der n-fach (n > 1) vorhandenen Sense-FETs 1, 1' über ein Signal an Klemme 10 (Select) selektierbar verbunden werden können. Zum Selektieren des Sense-FET-Bereichs ist Gate 20 des Power-FETs 18 über einen zusätzlichen FET 12 (Pass-Transistor) mit Gate 21 des Sense-Stromteils 8 des Sense-FETs 1 verbunden. Weiterhin besteht eine Verbindung von Gate 20 mit einem Ansteueranschluß 22 (Drivel). Das Gate des FET 12 führt zu Selektieranschluß 10 (Select1) und über Inverter 11 zum Gate von FET 13. Source-Anschluß von FET 13 ist mit dem Bezugspotential verbunden. Drain-Anschluß von FET 13 ist mit dem Gate des Sense-Stromteils 8 verbunden. Die Drain-Anschlüsse des Laststromteils 18 und des Sense-Stromteils 8 sind gemeinsam zu Klemme 15 geführt. Source-Anschluß 23 ist über Klemme 28 mit Referenzwiderstand 4 verbunden. Klemme 28 führt zu Verstärker 7, welcher ein weiterverarbeitbares Signal an Ausgang ADC der Schaltungsanordnung bereitgestellt. Das Signal an Ausgang ADC ist dann bei einer ordnungsgemäßen Funktion der Schaltung zum jeweils ausgewählten Spulenstrom proportional. Klemme ADC ist mit einem A/D-Wandler verbunden, welcher ein digitales Signal einer digitalen Überwachungsschaltung 39 zur Verfügung stellt, welche Selektierausgänge aufweist, mit denen die Sense-FETs in den Treiberstufen selektiert werden können.

Im Betrieb der Schaltungsanordnung nach Fig. 4 gibt das über Ausgang ADC geführte Signal den Strom durch diejenige Spule an, die durch einen high-Pegel an Klemme 10 ausgewählt ist, wobei an den übrigen Klemmen 10 der verbleibenden Baugruppen 24 zu dieser Zeit ein low-Pegel anliegen muß. Die Selektion der Treiberstufe 40 durch einen "high"-Pegel an Klemme 10 bewirkt ein Öffnen von FET 13 und ein Schließen von FET 12. Hierdurch wird der Sense-Stromteil des FETs 1 aktiviert, so daß Sense-Strom Iₛ durch Widerstand 4 fließt. Bei einem "low"-Pegel an Klemme 10 wird Sense-Stromteil 8 deaktiviert, so daß eine Strommessung durch einen "high"-Pegel an Klemme 10 an einer der übrigen Baugruppen 22 vorgenommen werden kann.

Der Sense-FET 1 in einer einzelnen Treiberstufe kann auch, wie in Fig. 3 dargestellt, zum Zwecke der Erhöhgung der Redundanz durch zwei parallel geschaltete Sense-FETs 1 und 1' entsprechend der Ausführungsform in Fig. 3 oder durch eine "Reihenschaltung", wie in Fig. 5 ersetzt werden. Auch die Widerstandselemente 4 lassen sich in Form mehrerer außerhalb des Substrats angeordneter diskreter Bauelemente redundant ausführen.

Wird gemäß dem Verfahren der Erfindung eine ungleiche Stromverteilung wie in Fig. 3 dargestellt durch Vergleich der an Sense-FETs 1 und 1' gemessenen Ströme in der Überwachungseinrichtung 39 festgestellt, wird ein Fehlersignal an Klemme F (Fig. 4) ausgegeben.

In Fig. 5 ist schematisch eine Schaltungsanordnung zur Ansteuerung einer induktiven Last 3 angegeben, worin neben einer Treiberstufe 25 zum Ansteuern der Last 3 zusätzlich eine Rezirkulationstreiberstufe 29 vorgesehen ist.

Die hier beschriebene Schaltungsanordnung hat den Vorteil, daß gegenüber der Schaltungsanordnung nach Fig. 3 zusätzlich auch Fehler des Leistungsteils im Sense-FET, welche beispielsweise eine allmähliche oder abrupte Änderung des Schaltwiderstandes R_{DSon} zu Folge haben, erkannt werden können. Zusätzlich kann entsprechend auch eine Fehler im Sense-FET der Rezirkulationsstufe erkannt werden.

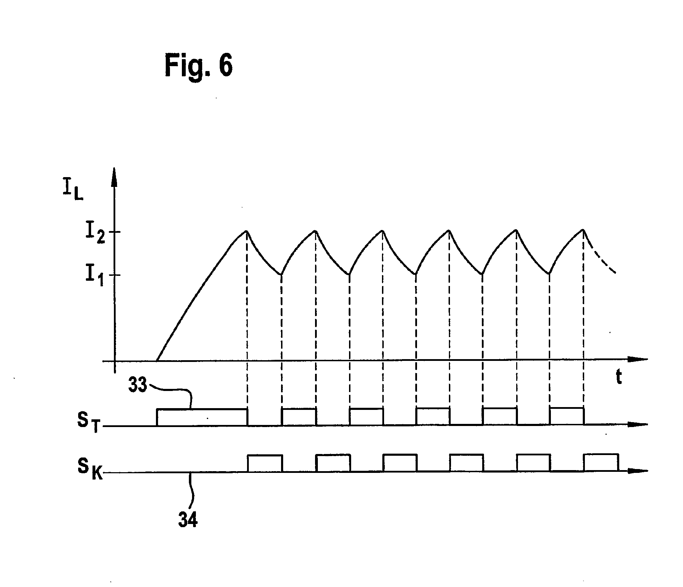

Die Funktionsweise der Schaltung wird an Hand von Fig. 6 erläutert. Durch Ansteuern von Treiberstufe 25 mittels eines rechteckförmigen Signals 33 an Klemme 19 kann der auf Grund der Spuleninduktivität in der Pulspause vorhandene Induktionsstrom I_{L} (Freilaufstrom) über die Rezirkulationsstufe 29 in die Spule zurückgespeist werden. Hierzu wird die Rezirkulationsstufe 29 mit einem zu Signal 33 an Klemme 30 komplementären Signal 34 angesteuert.

Treiberstufe 25 und Rezirkulationsstufe 29 können jeweils zweckmäßigerweise einen oder mehrere FETs umfassen.

Die Ansteuerung des Treibers 25 kann entsprechend der weiter oben beschriebenen Schaltung in Fig. 3 über eine Logik über Klemme 19, welche mit der Ansteuerleitung eines Halbleiterschaltelements verbunden ist, erfolgen. Über Klemme 30 wird ein Signal zugeführt, welches komplementär zum an Klemme 19 anliegenden Signal ist.

Wesentlich ist, daß sowohl Treiberstufe 25 als auch Rezirkulationsstufe 29 jeweils eine der zuvor beschriebenen Strommeßeinrichtungen umfaßt (z.B. einen Sense-FET in jeder Stufe). Hierdurch kann bei einer Ansteuerung der Spule nach dem Prinzip der Pulsweitenmodulation (PWM) der durch die Spule fließende Strom redundant bestimmt werden, wobei die Schaltungsanordnung gegenüber der parallelen Anordnung der Sense-FETs gemäß Fig. 3 den Vorteil hat, daß zusätzlich auch Halbleiterdefekte erkannt werden können, bei denen eine Veränderung des Schaltwiderstandes R_{DSon} auftritt. Unter der Annahme, daß ein entsprechender Defekt lediglich bei einem der vorhandenen Halbleiterschaltelemente auftritt (Einfachfehler), kann ein Defekt durch Vergleich des Stroms durch die Treiberstufe während der Ansteuerphase mit dem Freilaufstrom durch die Rezirkulationsstufe während der Ansteuerpause festgestellt werden.

Eine Strommessung läßt sich entsprechend Fig. 3 durch Abgriff der Spannungen an den Meßwiderständen 4 durchführen, wobei die abgegriffenen Spannungssignale auch hier durch Verstärkerstufen 7 verstärkt werden und über Ausgänge ADC1 und ADC2 an einen oder mehrere Analog-Digital-Wandler 38 weitergeleitet werden können.

Die zuvor beschriebene Schaltungsanordnung erlaubt die Erkennung von Abweichungen zwischen Treiberstrom und Freilaufstrom. Abweichungen können entstehen, wenn der gemessene Strom in der Treiberstufe oder in der Rezirkulationsstufe nicht mit dem tatsächlichen Spulenstrom übereinstimmt. In diesem Fall ist ein Defekt eines der Sense-FETs wahrscheinlich, was z.B. eine Abschaltung des Antiblockiersystems bewirkt. Neben Halbleiterdefekten können mittels der Schaltungsanordung gemäß Fig. 5 auch Nebenschlüsse, symbolisiert durch Widerstände 31 (Rp₂) und 32 (R_{P1}), welche entweder parallel zur Treiberstufe oder parallel zur Rezirkulationsstufe auf Grund eines Defektes entstehen, erkannt werden.

Bei einem Nebenschluß entsprechend einem Widerstand 32 wird durch Sense-FET 25 der Strom Iₛₑₙₛₑ₁ ≈ ILS = I_{L} + I_{Leak1} gemessen, wobei I_{L} der Strom durch Spule 3 und I_{Leak1} der Leckstrom über Widerstand 32 ist. Aufgrund der Parallelschaltung R_{Dson} und Rₚ₁ ergibt sich, daß Iₛₑₙₛₑ₁ auch den Strom I_{Leak1} mitumfaßt. Mit der Annahme, daß über Treiber 25 maximal eine Spannung von beispielsweise 1 V abfallen kann, ergibt sich I_{Leak1} < 1 V / R_{P1}. Nimmt man an, daß über die Rezirkulationsstufe ebenfalls eine Spannung von maximal etwa 1 V abfallen kann, wird nach dem Abschalten von FET 25 ein Rezirkulationsstrom Iₛₑₙₛₑ₂ ≈ I_{Recirc} = I_{L} - I_{Leak1}, mit I_{Leak1} < (V_{REFx} + 1 V) / Rₚ₁, hervorgerufen. Dies zeigt, daß der durch den Sense-FET bestimmte Treiberstrom bei einem positiven Leckstrom I_{Leak1} über Widerstand 32 bei einem Nebenschluß des Treibers 25 erhöht wird und der gemessene Rezirkulationsstrom I_{Recirc} in Sense-FET 29 erniedrigt wird, so daß sich eine durch die Schaltungsanordnung feststellbare Stromdifferenz zwischen Iₛₑₙₛₑ₁ und I_{Sense2} ergibt.

Im Fall eines Nebenschlusses parallel zur Rezirkulationsstufe, symbolisiert durch Widerstand 31 (Rₚ₂), wird während der Ansteuerphase ein höherer Strom I_{LS} = I_{L} + I_{Leak2} benötigt, als dies ohne Nebenschluß der Fall wäre. Auch hier gilt mit einem maximalen Spannungsabfall von 1 V an den Treiberstufen der Zusammenhang I_{Leak2} > (V_{REF} - 1 V) / Rₚ₂. Während der Freilaufphase, in der der Spulenstrom über Stufe 29 abfließt, wird im Sense-FET dieser Stufe ein Strom Iₛₑₙₛₑ₂ ≈ I_{L} = I_{Recirc} - I_{Leak2}, mit I_{Recirc} > -1 V / Rₚ₂, gemessen. Durch die Parallelschaltung des Einschaltwiderstandes R_{DSon} im Transistor des Rezirkulationstreibers und des Widerstandes Rₚ₂ wird ein zu kleiner Strom ISense2 gemessen. Es ergibt sich folglich eine durch die Schaltung erkennbare Stromdifferenz zwischen I_{Sense1} und I_{Sense2}.

Die im vorstehenden Absatz beschriebene Methode erlaubt die Erkennung von Nebenschlüssen unter der Voraussetzung, daß Widerstand 32 größer als Null ist. Im Fall eines Kurzschlusses parallel zu Treiberstufe 25 oder des Sense-FETs selbst ist eine Defekterkennung über die Stromdifferenz I_{Sense1} und Isense2 alleine nicht möglich. Daher ist in der Schaltungsanordnung nach Fig. 5 vorzugsweise zusätzlich eine Überwachungsschaltung mit einem Komparator 35 vorgesehen, welcher Klemme 15' (Spulenausgang) auf das Unterschreiten eines vorgegebenen Spannungspotentials hin überwacht. Durch zusätzliche Überwachung des Signals an Klemme 36, welches bei Auftreten des besagten Kurzschlusses von "high" auf "low" wechselt, kann auch dieser bisher nicht erkennbare Fehlerfall durch die Schaltungsanordnung festgestellt werden.

## Patentansprüche

1. Schaltungsanordnung, bei der eine Erkennung eines Defekts von elektronischen Bauelementen in einem elektronischen Steuergerät mit einem oder mehreren Ausgängen (15,15') zum Schalten von Lasten (3,3') durchgeführt wird, umfassend mehrere Halbleiterschaltelemente (1, 1', 1", 25, 29) mit jeweils Steuerkontakten (G) zum Anschluß einer Steuerleitung (2,16), mit Stromkontakten (S,D) zum Anschließen einer oder mehrerer Lasten (3,3') und mindestens eine Strommeßeinrichtung (4,5,6,7,8) zur Bestimmung des durch das Halbleiterschaltelement geführten Stroms, **dadurch gekennzeichnet, daß** der Strom (I_{L}), welcher einer Last (3,3') zugeführt wird, und der Strom (I_{Recirc}), welcher von dieser Last in die Schaltung zurückgespeist wird, durch mindestens zwei derselben Last zugeordneten Strommeßeinrichtungen bestimmt wird und eine Vergleichseinrichtung (38,39) vorhanden ist, welche die durch die Strommeßeinrichtungen gemessenen Ströme miteinander vergleicht, wobei auf eine Fehlfunktion eines Halbleiterschaltungselementes erkannt wird, wenn der Vergleich zweier Stromwerte (I_{S}, I_{Sense1}, I_{Sense2}) über den Strom, der durch eine Last (3,3') fließt, auf eine ungleiche Stromverteilung hindeutet.

2. Schaltungsanordnung nach Anspruch 1, **dadurch gekennzeichnet, daß** das Gate-Potential und/oder das Drain-Potential (37) von Halbleiterschaltelementen durch Vergleich mit einem Soll-Potential bestimmt wird und bei einer festgestellten Abweichung auf einen Schaltungsdefekt erkannt wird.

3. Schaltungsanordnung nach Anspruch 1 oder 2, **dadurch gekennzeichnet, daß** die Strommesseinrichtungen Sense-Halbleiterschaltelemente (1,1',25,29) umfassen.

4. Schaltungsanordnung nach einem der Ansprüche 1 bis 3, **dadurch gekennzeichnet, daß** die Sense-Halbleiterschaltelemente auf einem gemeinsamen Halbleitermaterial (9) integriert sind und zur Strombestimmung ein gemeinsames selektierbares Referenz-Bauelement (R_{S}*), insbesondere ein Referenz-Widerstand, vorgesehen ist, welches nicht auf dem Halbleitermaterial integriert ist.

5. Schaltungsanordnung nach Anspruch 4, **dadurch gekennzeichnet, daß** zur Strommessung der Spannungsabfall am Referenz-Bauelement (R_{S}*) bestimmt wird und abwechselnd jedes Halbleiterschaltelement durch eine Verbindungsschaltung (10...13) mit dem Referenzbauelement leitfähig verbunden werden kann.

6. Schaltungsanordnung nach mindestens einen der Ansprüche 1 bis 5, **dadurch gekennzeichnet, daß** mindestens zwei Lasten (3,3') durch jeweils einen der Last zugeordneten Treiber angesteuert werden und jeder Treiber mindestens ein Sense-Halbleiterschaltelement aufweist, dessen Sense-Stromteil (8) über einen Selektieranschluß (10) zuschaltbar ist.

7. Schaltungsanordnung nach mindestens einem der Ansprüche 1 bis 6, **dadurch gekennzeichnet, daß** die Halbleiterschaltelemente (1,1') mit einen gemeinsamen Ausgang (15) leitfähig so verbunden sind, daß bei Ausfall eines Halbleiterschaltelementes das funktionstüchtige Halbleiterschaltelement (1') die Schaltfunktion des ausgefallenen Halbleiterschaltelements (1) übernimmt.

8. Verwendung der Schaltungsanordnung nach den Ansprüchen 1 bis 7 in elektronischen Bremskraft- oder Fahrdynamikreglern für Kraftfahrzeuge.

## Claims

1. Circuit arrangement, in which a fault is identified in electronic components in an electronic controller having one or more outputs (15, 15') for switching loads (3, 3'), comprising a plurality of semiconductor switching elements (1, 1', 1", 25, 29) with respective control contacts (G) for connecting a control line (2, 16), with current contacts (S, D) for connecting one or more loads (3, 3'), and at least one current measuring device (4, 5, 6, 7, 8) for determining the current carried by the semiconductor switching element, **characterized in that** the current (I_{L}) which is supplied to a load (3, 3') and the current (I_{Recirc}) which is returned to the circuit by said load are determined by at least two current measuring devices associated with the same load, and a comparison device (38, 39) is present which compares the currents measured by the current measuring devices with one another, wherein a malfunction in a semiconductor switching element is identified if the comparison between two current values (I_{S}, I_{Sense1}, I_{Sense2}) by means of the current which flows through a load (3, 3') indicates an uneven current distribution.

2. Circuit arrangement according to Claim 1, **characterized in that** the gate potential and/or the drain potential (37) of semiconductor switching elements is determined by means of comparison with a target potential, and if a discrepancy is found then a circuit fault is identified.

3. Circuit arrangement according to Claim 1 or 2, **characterized in that** the current measuring devices comprise sense semiconductor switching elements (1, 1', 25, 29) .

4. Circuit arrangement according to one of Claims 1 to 3, **characterized in that** the sense semiconductor switching elements are integrated on a common semiconductor material (9) and for the purpose of current determination a common selectable reference component (R_{S}*), particularly a reference resistor, is provided which is not integrated on the semiconductor material.

5. Circuit arrangement according to Claim 4, **characterized in that** for the purpose of current measurement the voltage drop across the reference component (R_{S}*) is determined and each semiconductor switching element can alternately be conductively connected to the reference component by a connection circuit (10 ... 13).

6. Circuit arrangement according to at least one of Claims 1 to 5, **characterized in that** at least two loads (3, 3') are actuated by a respective driver which is associated with the load, and each driver has at least one sense semiconductor switching element, the sense current portion (8) of which can be connected by means of a selection connection (10).

7. Circuit arrangement according to at least one of Claims 1 to 6, **characterized in that** the semiconductor switching elements (1, 1') are conductively connected to a common output (15) such that if one semiconductor switching element fails then the operable semiconductor switching element (1') takes over the switching function of the failed semiconductor switching element (1).

8. Use of the circuit arrangement according to Claims 1 to 7 in electronic braking-force or driving-dynamics controllers for motor vehicles.

## Revendications

1. Circuit dans lequel est effectuée la détection d'un défaut de composants électroniques d'un appareil de commande électronique présentant une ou plusieurs sorties (15, 15') qui commutent des charges (3, 3'), le circuit comprenant
plusieurs éléments semi-conducteurs de commutation (1, 1', 1", 25, 29) dotés chacun de contacts de commande (G) destinés à être raccordés à un conducteur de commande (2, 16),
des contacts de courant (S, D) destinés à être raccordés à une ou plusieurs charges (3, 3') et
au moins un dispositif (4, 5, 6, 7, 8) de mesure de courant qui détermine le courant qui passe dans l'élément semi-conducteur de commutation,
**caractérisé en ce que**
le courant (I_{L}) apporté à une charge (3, 3') et le courant (I_{Recirc}) renvoyé par cette charge dans le circuit sont déterminés par au moins deux dispositifs de mesure de courant associés à la même charge,
et **en ce que** le circuit présente un dispositif de comparaison (38, 39) qui compare l'un à l'autre les courants mesurés par les dispositifs de mesure de courant, un fonctionnement défectueux d'un élément semi-conducteur de commutation étant détecté si la comparaison de deux valeurs de courant (I_{S}, Iₛₑₙₛₑ₁, Iₛₑₙₛₑ₂) indique une répartition inégale du courant qui traverse une charge (3, 3').

2. Circuit selon la revendication 1, **caractérisé en ce que** le potentiel de grille et/ou le potentiel de drain (37) d'éléments semi-conducteurs de commutation est déterminé par comparaison avec un potentiel de consigne et **en ce qu'**un défaut du circuit est détecté si un écart est constaté.

3. Circuit selon les revendications 1 ou 2, **caractérisé en ce que** les dispositifs de mesure de courant comprennent des éléments semi-conducteurs de commutation directifs (1, 1', 25, 29).

4. Circuit selon l'une des revendications 1 à 3, **caractérisé en ce que** les éléments semi-conducteurs de commutation directifs sont intégrés sur un matériau semi-conducteur (9) commun et **en ce que** pour la détermination du courant, le circuit présente un composant commun de référence (Rₛ*) sélectionnable, en particulier une résistance de référence, qui n'est pas intégrée sur le matériau semi-conducteur.

5. Circuit selon la revendication 4, **caractérisé en ce que** pour la mesure du courant, il détermine la chute de tension à travers le composant de référence (R_{S}*) et **en ce que** chaque élément semi-conducteur de commutation peut être relié de manière conductrice et en alternance au composant de référence par un circuit de liaison (10 ... 13).

6. Circuit selon au moins l'une des revendications 1 à 5, **caractérisé en ce qu'**au moins deux charges (3, 3') sont commandées chacune par un pilote associé à la charge et **en ce que** chaque pilote présente au moins un élément semi-conducteur de commutation directif dont la partie (8) de détection du sens du courant peut être raccordée par l'intermédiaire d'une borne de sélection (10).

7. Circuit selon au moins l'une des revendications 1 à 6, **caractérisé en ce que** les éléments semi-conducteurs de commutation (1, 1') sont reliés de manière conductrice à une sortie commune (15) de telle sorte qu'en cas de défaillance d'un élément semi-conducteur de commutation, l'élément semi-conducteur de commutation (1') fonctionnant correctement assure la fonction de commutation de l'élément semi-conducteur de commutation (1) défaillant.

8. Utilisation du circuit selon les revendications 1 à 7 dans des régulateurs électroniques de force de freinage ou de dynamique de roulage de véhicules automobiles.
